# EUROPEAN PATENT SPECIFICATION

(11) **EP 1 962 422 B1**
(45) Date of publication and mention of the grant of the patent: **16.09.2009**
(21) Application number: 06781183.6
(22) Date of filing: 18.07.2006
(51) Int. Cl.: H03H 7/01, H01P 1/20

(54) **BAND-PASS FILTER**
BANDPASSFILTER
FILTRE PASSE-BANDE

(30) Priority: 08.12.2005 JP 2005354657
(43) Date of publication of application: 27.08.2008
(73) Proprietor: Mitsubishi Electric Corporation, Chiyoda-ku Tokyo 100-8310 (JP)
(72) Inventor: NISHINO, Tamotsu, Tokyo 100-8310 (JP); MIYAZAKI, Moriyasu, Tokyo 100-8310 (JP); UCHIDA, Hiromitsu, Tokyo 100-8310 (JP)
(74) Representative: Pfenning, Meinig & Partner GbR
(86) International application number: PCT/JP2006/314162
(87) International publication number: WO 2007/066426

(56) References cited:
- JP-A- 06 350 374
- JP-A- 09 051 202
- JP-A- 63 206 029
- US-A- 5 933 770
- DRISCOLL M M: "The use of multi-pole bandpass filters and other multiple resonator circuitry as oscillator frequency stabilization elements" FREQUENCY CONTROL SYMPOSIUM, 1996. 50TH., PROCEEDINGS OF THE 1996 IEEE INTERNATIONAL. HONOLULU, HI, USA 5-7 JUNE 1996, NEW YORK, NY, USA,IEEE, US, 5 June 1996 (1996-06-05), pages 782-789, XP010199974 ISBN: 978-0-7803-3309-3
- LUCYSZYN S ET AL: "MMIC tunable active notch filter" ELECTRONICS LETTERS, IEE STEVENAGE, GB, vol. 32, no. 11, 23 May 1996 (1996-05-23), pages 980-981, XP006005169 ISSN: 0013-5194
- WEN J G ET AL: "Suppression of Reflection Coefficients of Surface Acoustic Wave Filters by Using Quadrature Hybrids" 2005 EUROPEAN MICROWAVE CONFERENCE CNIT LA DEFENSE, PARIS, FRANCE OCT. 4-6, 2005, PISCATAWAY, NJ, USA,IEEE, vol. 1, 4 October 2005 (2005-10-04), pages 553-556, XP010904047 ISBN: 978-2-9600551-2-2

## Description

### TECHNICAL FIELD

The present invention relates to a band-pass filter which includes a plurality of connected unit circuits, in each of which a series circuit of a coil and a capacitor is connected with a parallel circuit of a coil and a capacitor, and which is used for high-frequency communication or the like.

### BACKGROUND ART

A high-frequency filter circuit obtained by connecting a plurality of unit circuits each including a series circuit of a coil and a capacitor and a parallel circuit of a coil and a capacitor has a steep frequency characteristic. However, a pass phase change of a high-frequency signal is significant, so it is difficult to use the high-frequency filter circuit for communication devices. On the other hand, a band elimination frequency characteristic is steep and a reflection phase change is small.

The high-frequency circuit obtained by connecting the plurality of unit circuits each including the series circuit of the coil and the capacitor and the parallel circuit of the coil and the capacitor as described above is called a right and left mixing circuit. It has been known that when element values for the coils and the capacitors are suitably selected, a circuit having a desirable elimination frequency is obtained (see, for example, Non-patent Document 1).

There is also a micro-mechanical high-frequency device which is called an RF micro electro-mechanical systems (MEMS) device and manufactured by microfabrication. The micro-mechanical high-frequency device receives widespread attention as a low-loss and low-distortion device, and a micro-mechanical variable capacitor using a MEMS technology has been under development (see, for example, Non-patent Document 2).

Non-patent Document 1:C. Caloz, and T Itoh, "Novel Microwave Devices and Structures Based on the Transmission Line Approach of Meta-Materials", International Microwave Symposium 2003, pp. 195-198
Non-patent Document 2: J. J. Yao, S. Park and J. DeNatale, "HIGH TUNING-RATIO MEMS-BASED TUNABLE CAPACITORS FOR RF COMMUNICATIONS APPLICATIONS", Solid State Sensor and Actuator Workshop, Hiltion Head Island, SC June 1998 pp. 124-127. Another example is disclosed in "FREQUENCY CONTROL SYMPOSIUM, 1996. 50TH., PROCEEDINGS OF THE 1996 IEEE INTERNATIONAL. HONOLULU, HI, USA 5-7 JUNE 1996, NEW YORK, NY" USA,IEEE, US, 5 June 1996 , pages 782-789 "The use of multi-pole bandpass filters and other multiple resonator circuitry as oscillator frequency stabilization elements"; DRISCOLL M.

### DISCLOSURE OF THE INVENTION

### PROBLEMS TO BE SOLVED BY THE INVENTION

As described above, a high-frequency circuit obtained by connecting a plurality of unit circuits, in each of which a series circuit of a coil and a capacitor is connected with a parallel circuit of a coil and a capacitor, has advantages in that the band elimination frequency characteristic is steep and the reflection phase change is small. On the other hand, a pass phase change of a high-frequency signal is significant, so it is difficult to use the high-frequency filter circuit for communication devices.

The present invention has been made to solve the above-mentioned problem, and an object thereof is to obtain a band-pass filter having a small phase change in a pass band and a steep frequency characteristic.

### MEANS FOR SOLVING THE PROBLEMS

A band-pass filter according to the present invention includes: a four-terminal pair 90-degree hybrid circuit for distributing power into two directions with a phase difference of 90 degrees; and a band elimination filter circuit including a plurality of unit circuits connected to each other, each of the plurality of unit circuits including a series circuit of a coil and a capacitor and a parallel circuit of a coil and a capacitor, which are connected with each other, input terminals of the plurality of unit circuits being connected with coupling terminals of the hybrid circuit, and output terminals of the plurality of unit circuits being terminated with resistors having impedance values equal to an output impedance.

### EFFECTS OF THE INVENTION

According to the present invention, the four-terminal pair 90-degree hybrid circuit for distributing power into two directions with the phase difference of 90 degrees is used such that reflection waves at the elimination frequency of the band elimination filter circuits are passed therethrough and reflection waves at a pass frequency of the band elimination filter circuit are consumed by the termination resistors. Therefore, a band-pass filter having a small phase change in a pass band and a steep frequency characteristic can be obtained.

### BRIEF DESCRIPTION OF THE DRAWINGS

Fig. 1 is a structural diagram showing a unit circuit included in a band elimination filter of a band-pass filter according to Embodiment 1 of the present invention.
Fig. 2 is a graph showing a pass amplitude characteristic of the band elimination filter circuit in which 16 unit circuits, each of which is shown in Fig. 1, are connected.
Fig. 3 is a graph showing a pass phase characteristic of a band elimination filter circuit equal to that shown in Fig. 2.
Fig. 4 is a structural diagram showing the band-pass filter according to Embodiment 1 of the present invention.
Fig. 5 is a graph showing a pass amplitude characteristic from an input terminal to an output terminal of the band-pass filter according to Embodiment 1 of the present invention.
Fig. 6 is a graph showing a pass phase characteristic from the input terminal to the output terminal of the band-pass filter according to Embodiment 1 of the present invention.
Fig. 7 is a graph showing a pass amplitude characteristic of the band-pass filter according to Embodiment 1 of the present invention in a case where a series capacitor value of the unit circuit is adjusted.
Fig. 8 is a graph showing a pass amplitude characteristic of the band-pass filter according to Embodiment 1 of the present invention in a case where a parallel capacitor value of the unit circuit is adjusted.

### BEST MODE FOR CARRYING OUT THE INVENTION

### Embodiment 1

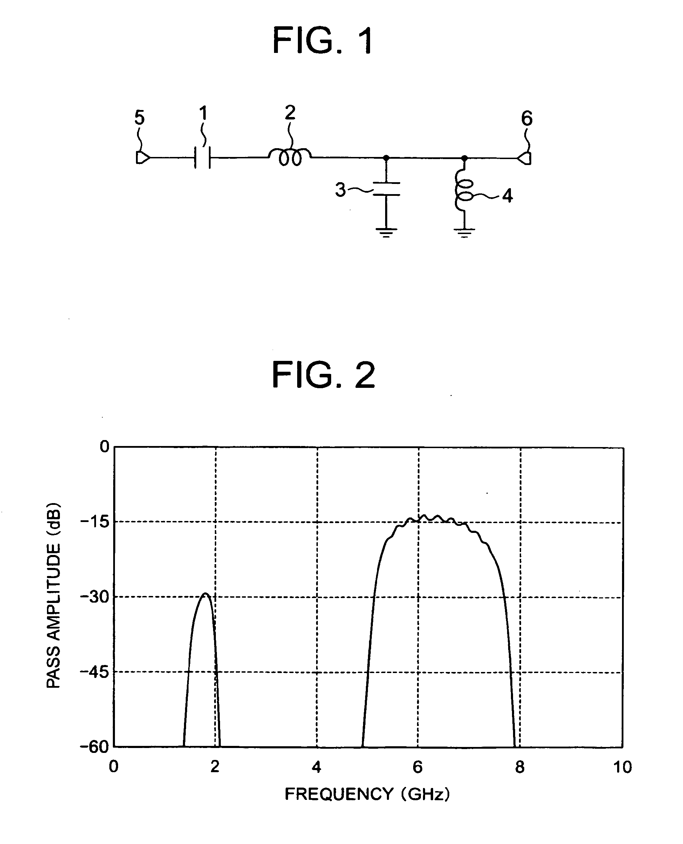

Fig. 1 is a structural diagram showing a unit circuit included in a band elimination filter circuit of a band-pass filter according to Embodiment 1 of the present invention. As shown in Fig. 1, the unit circuit includes a series circuit of a capacitor 1 and a coil 2 and a parallel circuit of a capacitor 3 and a coil 4, which are connected with each other, and further includes an input terminal 5 and an output terminal 6.

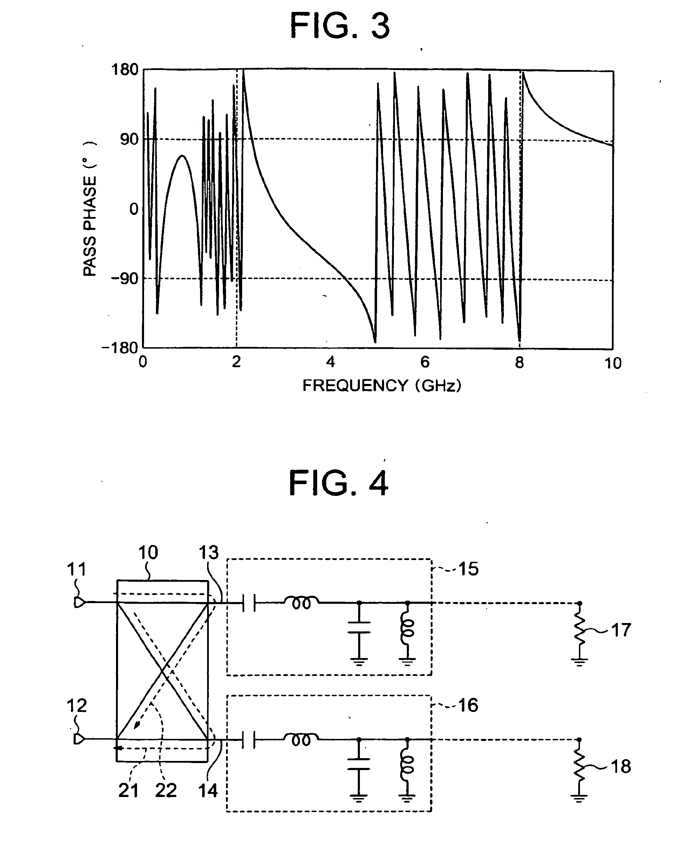

Figs. 2 and 3 show, for example, a pass amplitude-frequency characteristic and a pass phase-frequency characteristic of a band elimination filter circuit including 16 connected unit circuits, in each of which a value of the capacitor 1 is 1 pF, a value of the coil 2 is 1 nH, a value of the capacitor 3 is 3 pF, and a value of the coil 4 is 2 nH.

Fig. 4 is a structural diagram showing the band-pass filter according to Embodiment 1 of the present invention. As shown in Fig. 4, the band-pass filter according to Embodiment 1 of the present invention includes: a four-terminal pair 90-degree hybrid circuit 10 for distributing power into two directions with a phase difference of 90 degrees; and band elimination filter circuits 15 and 16, in each of which a plurality of unit circuits as shown in Fig. 1 are connected, and in which input terminals are connected with coupling terminals 13 and 14 of the 90-degree hybrid circuit 10 and output terminals are terminated with resistors 17 and 18 having impedance values equal to an output impedance.

The 90-degree hybrid circuit 10 includes an input terminal 11, an output terminal 12, and the coupling terminals 13 and 14. When a pass phase from the input terminal 11 to the coupling terminal 13 is used as reference, a pass phase from the input terminal 11 to the coupling terminal 14 is delayed by 90 degrees. When a pass phase from the coupling terminal 14 to the output terminal 12 is used as reference, a pass phase from the coupling terminal 13 to the output terminal 12 is delayed by 90 degrees. The coupling terminals 13 and 14 are connected with the band elimination filter circuits in each of which sixteen unit circuits 15 or 16 as shown in Fig. 1 are arranged. Final terminals of the band elimination filter circuits are terminated with the resistors 17 and 18 in order to prevent reflection.

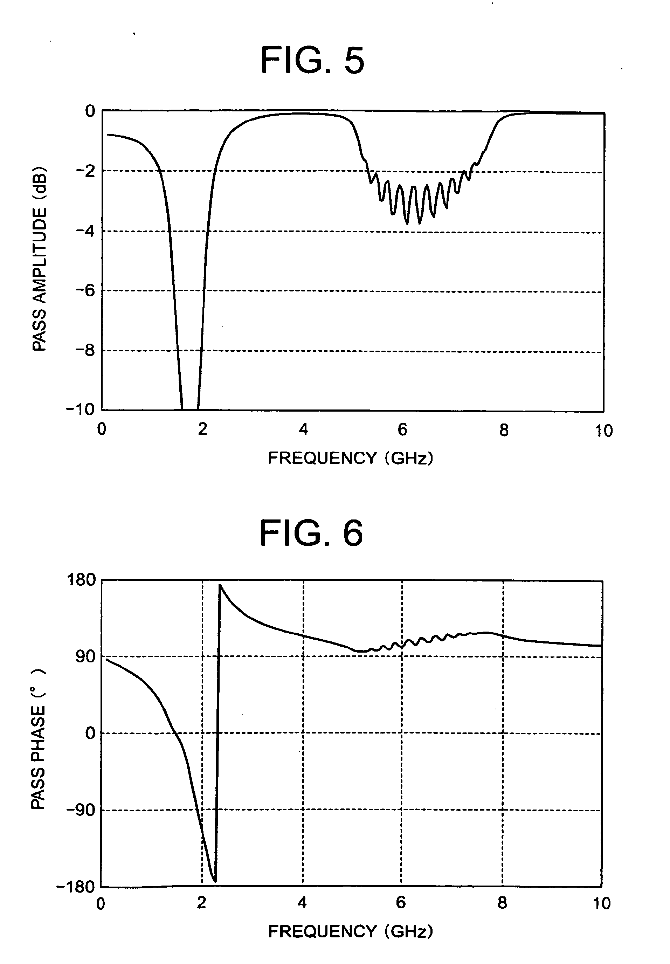

Fig. 5 shows a frequency characteristic of a pass amplitude from the input terminal 11 to the output terminal 12 of the circuit shown in Fig. 4. In this case, a quality factor of the capacitor and the coil is set to 30. Fig. 6 shows a frequency characteristic of a pass phase from the input terminal 11 to the output terminal 12 of the circuit shown in Fig. 4.

Next, an operation will be described. For example, a high-frequency signal whose frequency is 4 GHz is inputted from the input terminal 11, passes through the hybrid circuit 10, and enters, with an equal amplitude, a 16-stage band elimination filter circuit in which the unit circuit 15 is provided in a first stage (right and left mixing circuit) and a 16-stage band elimination filter circuit in which the unit circuit 16 is provided in a first stage (right and left mixing circuit). Because 4 GHz is an elimination frequency, the signal is reflected at a portion close to the first stage. A signal reflected at the coupling terminal 13 is transferred with an equal amplitude to the input terminal 11 and the output terminal 12.

On the other hand, a signal reflected at the coupling terminal 14 is also transferred with an equal amplitude to the input terminal 11 and the output terminal 12. At this time, as compared with a signal transferred in the order of the input terminal 11, the coupling terminal 13, and the input terminal 11, a signal transferred in the order of the input terminal 11, the coupling terminal 14, and the input terminal 11 is delayed in phase by 180 degrees. Therefore, the signals are cancelled with each other, so the signals are not transferred to the input terminal 11.

In contrast to this, a signal transferred in the order of the input terminal 11, the coupling terminal 13, and the output terminal 12, and a signal transferred in the order of the input terminal 11, the coupling terminal 14, and the output terminal 12 are delayed by 90 degrees. Therefore, the signals are strengthened with each other at the output terminal 12.

Therefore, the signal inputted to the input terminal 11 is transferred to the output terminal 12, except for a loss occurring at the time of reflection at the 16-stage right and left mixing circuit in which the unit circuit 15 is provided in the first stage, a loss occurring at the time of reflection at the 16-stage right and left mixing circuit in which the unit circuit 16 is provided in the first stage, and a loss occurring at the time of passing through the 90-degree hybrid circuit 10.

Next, for example, a high-frequency signal whose frequency is 1.8 GHz is inputted from the input terminal 11, passes through the hybrid circuit 10, and enters, with an equal amplitude, the 16-stage right and left mixing circuit in which the unit circuit 15 is provided in the first stage and the 16-stage right and left mixing circuit in which the unit circuit 16 is provided in the first stage. The right and left mixing circuits extend to the resistors 17 and 18 in order to pass the signal of 1.8 GHz through the circuits. Because the termination resistors 17 and 18 are made equal in impedance to the right and left mixing circuits in order to prevent reflection, the entire signals are consumed by the resistors. Therefore, the signal inputted to the input terminal 11 is not reflected at the input terminal 11 and not outputted to the output terminal 12.

When the values of the capacitors of the unit circuits 15 and 16 are adjusted, pass frequencies and elimination frequencies of the right and left mixing circuits change, thereby changing a pass band of the band-pass filter combined with the 90-degree hybrid circuit.

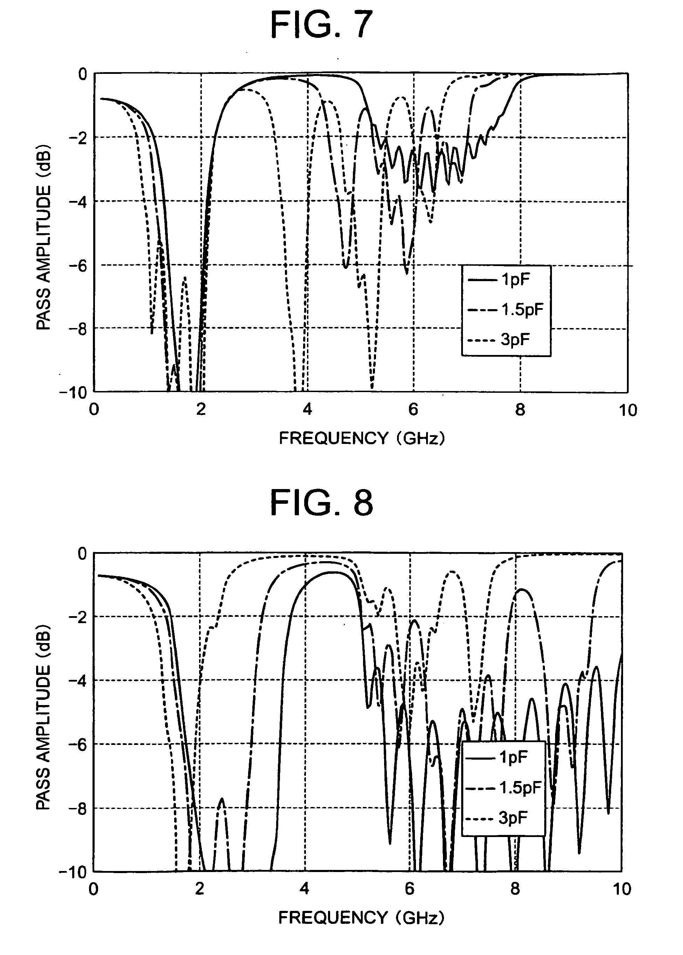

Fig. 7 shows a frequency characteristic of a pass amplitude from the input terminal 11 to the output terminal 12 of the circuit shown in Fig. 4 in the case where a value of the capacitor 1 of the unit circuit shown in Fig. 1 is adjusted to 1 pF, 1.5 pF, and 3 pF. Fig. 8 shows a frequency characteristic of a pass amplitude from the input terminal 11 to the output terminal 12 of the circuit shown in Fig. 4 in the case where a value of the capacitor 3 of the unit circuit shown in Fig. 1 is adjusted to 1 pF, 1.5 pF, and 3 pF.
In this way, when the values of the capacitors of the unit circuits 15 and 16 are adjusted, the pass band can be varied.

In this embodiment, a variable capacitor whose capacitance value can be adjusted to change the pass band can be used as the capacitor included in the unit circuit. When a micro-mechanical variable capacitor whose capacitance value can be adjusted by a micro machine manufactured by microfabrication is used as the variable capacitor, a high quality factor can be realized. Therefore, a reflection loss becomes smaller, with the result that a loss of a variable band-pass filter combined with the 90-degree hybrid circuit can be reduced.

Alternatively, it is possible to provide any one or both of a stub line which is used instead of the coil included in the unit circuit and which has the same inductance value as the coil, and a stub line which is used instead of the capacitor included in the unit circuit and which has the same capacitance value as the capacitor. That is, it is possible to embody a structure using the stub line serving as a distributed constant element instead of the capacitor or coil serving as a distributed constant element.

Further, when the stub line which has the same capacitance value as the capacitor is used instead of the capacitor included in the unit circuit, for example, a line length of the stub line is made adjustable. Therefore, the capacitance value can be adjusted to change the pass band.

As described above, according to the present invention, the four-terminal pair 90-degree hybrid circuit for distributing power into two directions with the phase difference of 90 degrees is used such that reflection waves at the elimination frequency of the band elimination filter circuits are passed therethrough and the reflection waves at the pass frequency of the band elimination filter circuit are consumed by the termination resistors. Therefore, a band-pass filter having a small phase change in a pass band and a steep frequency characteristic can be obtained. The pass waves are absorbed by the termination resistor at the pass frequency of the band elimination filter circuits, so there is obtained an effect of influencing a circuit provided in a preceding stage of each of the filter circuits.
It is also possible to obtain a band-pass filter in which the values of the capacitors of the band elimination filter circuits are adjusted to change a pass frequency band.
Further, when the stub line is used instead of the capacitor or the coil, a small capacitance value and a small inductance value which are required at a high frequency can be easily realized.

### INDUSTRIAL APPLICABILITY

According to the band-pass filter of the present invention, a phase change in a pass band is small and a steep frequency characteristic can be obtained. In a communication system using a portable terminal, the band-pass filter can be applied to a cognitive radio type portable terminal which automatically detects an available frequency which is not used in the communication system by itself and then starts communication.

## Claims

1. A band-pass filter, comprising:
a four-terminal pair 90-degree hybrid circuit (10) for distributing power into two directions with a phase difference of 90 degrees; and
a band elimination filter circuit (15, 16) including a plurality of unit circuits connected via the hybrid circuit (10) to each other, each of the plurality of unit circuits including a series circuit of a coil (2) and a capacitor (1) and a parallel circuit of a coil (4) and a capacitor (3), which are connected with each other, input terminals of the plurality of unit circuits being connected with coupling terminals (13, 14) of the hybrid circuit, and output terminals of the plurality of unit circuits being terminated with resistors (17, 18) having impedance values equal to an output impedance.

2. The band-pass filter according to claim 1, wherein the coil (2, 4) included in the unit circuits comprises a stub line equal in inductance value thereto.

3. The band-pass filter according to claim 1, wherein the capacitor (1, 3) included in the unit circuits comprises a stub line equal in capacitance value thereto.

4. The band-pass filter according to claim 1, wherein the capacitor (1, 3) included in the unit circuits comprises a variable capacitor whose capacitance value can be adjusted to change a pass band.

5. The band-pass filter according to claim 3, wherein the stub line has a variable line length so that the capacitance value is made variable to change a pass band.

## Patentansprüche

1. Bandpassfilter, welches aufweist:
eine Vierfach-Anschlusspaar-90-Grad-Hybridschaltung (10) zum Verteilen von Leistung in zwei Richtungen mit einer Phasendifferenz von 90 Grad; und
eine Bandeliminierungs-Filterschaltung (15, 16), enthaltend mehrere Schaltungseinheiten, die über die Hybridschaltung (10) miteinander verbunden sind, wobei jede der mehreren Schaltungseinheiten eine Reihenschaltung aus einer Spule (2) und einem Kondensator (1) und eine Parallelschaltung aus einer Spule (4) und einem Kondensator (3) enthält, die miteinander verbunden sind, Eingangsanschlüsse der mehreren Schaltungseinheiten mit Kopplungsanschlüssen (13, 14) der Hybridschaltung verbunden sind, und Ausgangsanschlüsse der mehreren Schaltungseinheiten durch Widerstände (17, 18) mit Impedanzwerten, die einer Ausgangsimpedanz gleich sind, abgeschlossen sind.

2. Bandpassfilter nach Anspruch 1, bei dem die in den Schaltungseinheiten enthaltene Spule (2, 4) eine Stichleitung aufweist, die einen hierzu gleichen Induktivitätswert hat.

3. Bandpassfilter nach Anspruch 1, bei dem der in den Schaltungseinheiten enthaltene Kondensator (1, 3) eine Stichleitung mit hierzu gleichem Kapazitätswert aufweist.

4. Bandpassfilter nach Anspruch 1, bei dem der in den Schaltungseinheiten enthaltene Kondensator (1, 3) einen variablen Kondensator aufweist, dessen Kapazitätswert eingestellt werden kann, um ein Durchlassband zu ändern.

5. Bandpassfilter nach Anspruch 3, bei dem die Stichleitung eine variable Leitungslänge derart hat, dass der Kapazitätswert variabel ist, um ein Durchlassband zu ändern.

## Revendications

1. Filtre passe-bande, comprenant :
un circuit hybride à 90 degrés à quatre bornes (10) destiné à distribuer une puissance dans deux directions avec une différence de phase de 90 degrés ; et
un circuit de filtre à élimination de bande (15, 16) qui comprend une pluralité de circuits unitaires connectés entre eux par l'intermédiaire du circuit hybride (10), chacun de la pluralité de circuits unitaires comprenant un circuit série constitué d'une bobine (2) et d'un condensateur (1), et un circuit parallèle constitué d'une bobine (4) et d'un condensateur (3), qui sont connectés les uns aux autres, les bornes d'entrée de la pluralité de circuits unitaires étant connectées à des bornes de raccordement (13, 14) du circuit hybride, et les bornes de sortie de la pluralité de circuits unitaires étant terminées par des résistances (17, 18) qui présentent des valeurs d'impédance égales à une impédance de sortie.

2. Filtre passe-bande selon la revendication 1, dans lequel la bobine (2, 4) incluse dans les circuits unitaires comprend une ligne d'adaptation dont la valeur de l'inductance est égale à celle-ci.

3. Filtre passe-bande selon la revendication 1, dans lequel le condensateur (1, 3) inclus dans les circuits unitaires comprend une ligne d'adaptation dont la valeur de la capacité est égale à celle-ci.

4. Filtre passe-bande selon la revendication 1, dans lequel le condensateur (1, 3) inclus dans les circuits unitaires comprend un condensateur variable dont la valeur de la capacité peut être réglée de manière à modifier la bande passante.

5. Filtre passe-bande selon la revendication 3, dans lequel la ligne d'adaptation présente une longueur de ligne variable de telle sorte que la valeur de la capacité soit rendue variable de manière à modifier la bande passante.
